# EUROPEAN PATENT SPECIFICATION

(11) **EP 3 706 126 B1**
(45) Date of publication and mention of the grant of the patent: **23.03.2022**
(21) Application number: 20154193.5
(22) Date of filing: 28.01.2020
(51) Int. Cl.: G11C 13/00, G11C 11/16

(54) **TECHNIQUES TO MITIGATE SELECTION FAILURE FOR A MEMORY DEVICE**
VERFAHREN ZUR VERMINDERUNG DES AUSWAHLFEHLERS FÜR EINE SPEICHERVORRICHTUNG
TECHNIQUES POUR ATTÉNUER UNE DÉFAILLANCE DE SÉLECTION POUR UN DISPOSITIF DE MÉMOIRE

(30) Priority: 07.03.2019 US 201916295800
(43) Date of publication of application: 09.09.2020
(73) Proprietor: Intel Corporation, Santa Clara, CA 95054 (US)
(72) Inventor: BANERJEE, Koushik, Milpitas, CA 95035 (US)
(74) Representative: Rummler, Felix

(56) References cited:
- US-A1- 2009 244 962
- US-B1- 9 721 657
- US-B1- 9 842 644
- JUNSANGSRI PILIN ET AL: "On the drift behaviors of a phase change memory (PCM) cell", 2013 13TH IEEE INTERNATIONAL CONFERENCE ON NANOTECHNOLOGY (IEEE-NANO 2013), IEEE, 5 August 2013 (2013-08-05), pages 1145-1150, XP032559495, ISSN: 1944-9399, DOI: 10.1109/NANO.2013.6720800 [retrieved on 2014-01-23]

## Description

### TECHNICAL FIELD

Examples described herein are generally related to techniques to mitigate selection failure for memory cells included in a memory device due to threshold voltage drift.

### BACKGROUND

Types of memory such as non-volatile memory may have reliability issues caused by a tendency of non-volatile memory cells having separate threshold voltages, hereinafter referred to as "Vt drift" over time. Memory cells programmed to states using higher Vts such as memory cells programmed to a "RESET" state (e.g., store a value of "0") may drift over time such that a risk of write selection failure increases for each unit of time until a new write or a refresh write is made to these memory cells. In other words, post-drift Vt after one or more units of time (e.g., 48 hours) may result in a higher Vt than a maximum write selection bias voltage if a new write or refresh write is not implemented before the expiration of the one or more units of time. The higher Vt than a maximum write selection bias voltage may cause a memory cell to become unprogrammable or unable to reliably store data.

US 9 842 644 B1 describes a method for operating a memory device comprising a plurality of memory cells, the method may include: performing a first refresh operation comprising sequentially applying a recovery pulse to each of the plurality of memory cells and repeating the sequential application of the recovery pulse to each of the plurality of memory cells for a predetermined number of times; and performing a second refresh operation comprising sequentially re-writing data of each of the plurality of memory cells once after the first refresh operation is performed for the predetermined number of times.

### SUMMARY OF INVENTION

The present invention is defined in the independent claims. Preferred features are recited in the dependent claims. In the following description, any embodiment referred to and not falling within the scope of the claims is merely an example useful to the understanding of the invention.

### BRIEF DESCRIPTION OF THE DRAWINGS

**FIG. 1** illustrates an example system
**FIG. 2** illustrates an example array portion.
**FIG. 3** illustrates example distributions.
**FIG. 4** illustrates an example graph.
**FIG. 5** illustrates an example comparison of memory cell voltage bias.
**FIG. 6** illustrates example first scheme.
**FIG. 7** illustrates example second scheme.
**FIG. 8** illustrates an example block diagram for an apparatus.
**FIG. 9** illustrates an example of a logic flow.
**FIG. 10** illustrates an example of a storage medium.
**FIG. 11** illustrates an example computing platform.

### DETAILED DESCRIPTION

As contemplated in the present disclosure, Vt drift over one or more units of time may result in a write selection failure for a non-volatile memory cell. In particular, for a non-volatile memory cell programmed to a RESET state. A type of non-volatile memory architecture that may include resistive types of memory cells such as phase change memory (PCM) may be susceptible to this type of Vt drift. In some examples, PCM may include memory cells composed of chalcogenide phase change material (e.g., chalcogenide glass). Chalcogenide-based memory cells may be characterized as resistive types of memory cells that face possible reliability issues due to Vt drift over time. For example, a chalcogenide-based memory cell's threshold voltage may continue to increase over one or more units of time if a new write or a refresh write is not implemented within a given amount of time. Eventually, the chalcogenide-based memory cell's threshold voltage may drift above a maximum selection bias voltage. A technique to mitigate this Vt drift is to implement a single refresh write of chalcogenide-based memory cells at a fixed interval that resets the Vt drift such that a Vt for the chalcogenide-based memory cells may be shifted to be less than the maximum write selection bias voltage.

A technique to mitigate Vt drift that is based on a single refresh write on a fixed interval may have two disadvantages. A first disadvantage is that there is no validation that the single refresh write was successful in resetting the Vt drift such that a Vt for the chalcogenide-based memory cells is less than the maximum selection bias voltage. For example, if the post-drift Vt was already higher than the maximum selection bias, then a memory cell targeted for a refresh write may not be selected for the refresh write and thus the Vt drift would not be successfully reset. This may lead to unacceptable high bit error rates for a memory device that includes the memory cell. A second disadvantage is that Vt drift has strong correlations to materials, manufacturing processes or programming algorithms for resistive types of memory cells such as chalcogenide-based memory cells. Therefore, a fixed interval may not account for possible variabilities in materials, manufacturing processes or programming algorithms. The possible variabilities may cause or lead to additional selection failures. The examples described herein may address the above-mentioned disadvantages as well as other challenges associated with Vt drift.

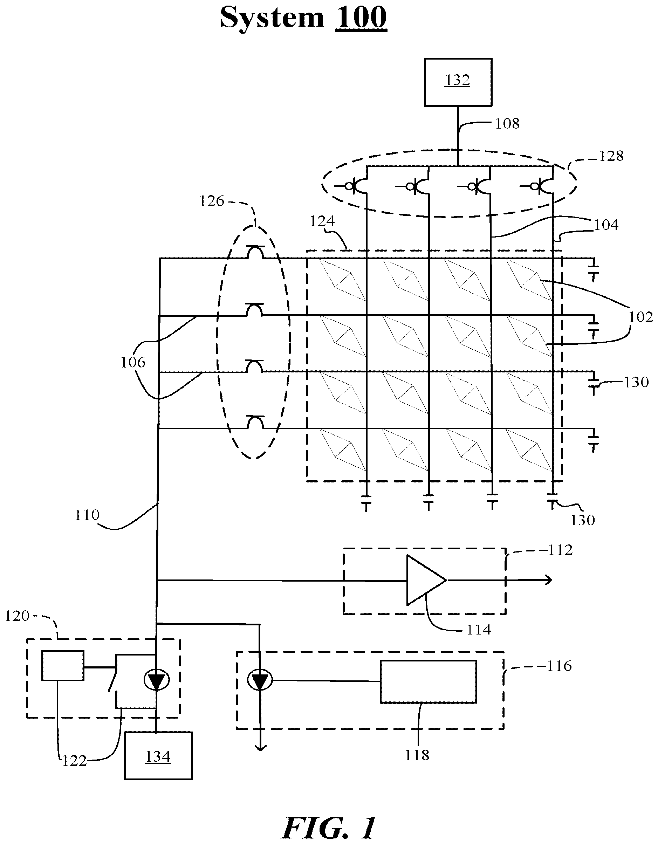

**FIG. 1** illustrates an example system 100. In some examples, as shown in FIG. 1, system 100 includes memory cells 102, which may be configured in an array. Memory cells 102 may include, for example, a phase change material such as, but not limited to, a chalcogenide glass that may be switched between crystalline and amorphous states with the application of heat produced by an electric current. A state (e.g., crystalline/amorphous) of a phase change material may correspond with a logical value (e.g., 1 or 0) of one or more memory cells 102. Subject matter of this disclosure is not limited in this regard, and examples may include other types of architectures and/or other types of resistive materials included in memory cells for memory devices.

According to some examples, system 100 may also include bit-lines 104 and word-lines 106 coupled to memory cells 102, as shown in FIG. 1. Bit-lines 104 and word-lines 106 may be configured such that each memory cell included in memory cells 102 may be disposed at an intersection of each individual bit-line and word-line. Voltage biases may be applied to a target memory cell of memory cells 102 using a word-line from word-lines 106 and a bit-line from among bit-lines 104 to program the target memory cell for a write operation. Respective bit-line drivers 128 may be coupled to respective bit-lines 104 and respective word-line drivers 126 may be coupled to respective word-lines 106 to facilitate decoding/selection of memory cells 102, as shown in FIG. 1. Also, respective capacitors 130 may be coupled to respective bit-lines 104 and respective word-lines 106, as shown in FIG. 1.

In some examples, system 100 may be a memory device that includes one or more tiles 124. For these examples, the one or more tiles 124 may be arranged as a portion of a memory array that includes word-lines 106, bit-lines 104, and memory cells 102 that may be treated as a discrete unit during a selection operation of a target memory cell. That is, in some examples, each of the one or more tiles 124 is a unit of the memory array that is biased to select one or more target memory cells (e.g., a bit or bits) in the array. The one or more tiles 124 shown in FIG. 1 may include an array of four word-lines and four bit-lines ( 4WL x 4BL); however, other tile sizes may be used in other examples having either equal ratios of word-lines and bit-lines or unequal ratios (e.g., 2 WL for every 1 BL or 2 BL for every 1 WL). The one or more tiles 124 may be part of any memory layer of a stacked memory configuration. For example, the one or more tiles 124 may be part of a memory layer formed on another memory layer. Additional word-line drivers and/or bit-lines drivers may be provided for each memory layer.

According to some examples, bit-lines 104 may couple with a bit-line electrode or path 108, which may further couple with a bit-line supply 132 that is configured to provide an electrical supply for bit-lines 104. Also, word-lines 106 may couple to a word-line electrode or path 110, which may further couple with a word-line supply 134 that is configured to provide an electrical supply for word-lines 106. Bit-line electrode 108 and the word-line electrode 110 may each be a current path to memory cells 102. Word-line drivers 126 and bit-line drivers 128 may each include single or multiple transistors per electrode according to various examples. For examples where multiple transistors are used for word-line drivers 126 and bit-line drivers 128, the multiple transistors may be coupled to additional voltage supplies using additional word-line and/or bit-line electrodes that may similarly comport with examples described herein. For example, a first word-line electrode may provide a first voltage supply to one or more selected memory cells and second word-line electrode may provide a second voltage supply to one or more de-selected memory cells.

In some examples, system 100 includes sensing circuitry 112 coupled to word-line electrode 110. For these examples, sensing circuitry 112 may use word-line electrode 110 as an electrical node for performing a read operation, such as a sense operation, of one or more memory cells included in memory cells 102. Sensing circuitry 112 may include a voltage comparator 114. For example, sensing circuitry 112 may include a word-line load connected to word-line electrode 110 to convert a current on the word-line electrode 110 to a voltage that is a first input to the voltage comparator 114. An equivalent word-line load may be connected to a reference current (not shown) to provide a voltage that is a second input to voltage comparator 114. When a particular word-line and bit-line are selected in system 100, the word-line load on word-line electrode 110 may convert the current on the selected word-line to a voltage. Leakage components of the current may be mitigated by respectively selecting a bias voltage for all other unselected word-lines and bit-lines for de-selected memory cells of memory cells 102 that may reduce or minimize leakage. Capacitive components of the current may be mitigated by allowing sufficient time for the capacitive components to dissipate. The current that is converted to the first input to voltage comparator 114 may correspond with the current of the selected or target memory cell. The reference current may be selected such that the current of the target or selected memory cell is lower than the reference current before snap-back of the target or selected memory cell and higher than the reference current after snap-back of the target memory cell. In this manner, an output of voltage comparator 114 may be indicative of a state of the targeted or selected memory cell as part of a snap-detect read of the targeted or selected memory cell. A latch (not shown) may be coupled to the voltage comparator 114 to store information associated with the snap-detect read operation. As described more below, one or more mitigation schemes may be implemented using various selection bias levels for snap-detect read operations to validate whether a refresh write has successfully reset a Vt drift for one or more targeted memory cells. Examples are not limited to having sense circuitry 112 using a word-line electrode such as word-line electrode 110 to perform a sense operation. In other examples sense circuitry may use a bit-line electrode such as bit-line electrode 108 to perform a sense operation.

According to some examples, system 100 may also include write circuitry 116 coupled to word-line electrode 110. Write circuitry 116 may use word-line electrode 110 as an electrical node for performing a write operation, such as a SET or RESET operation, of one or more memory cells from among memory cells 102. Write circuitry 116 may include a current profile generator 118 that generates a current profile for performing the write operation. Examples are not limited to having write circuitry 116 using a word-line electrode such as word-line electrode 110 to perform a write operation. In other examples write circuitry may use a bit-line electrode such as bit-line electrode 108 to perform a sense operation.

In some examples, memory device 100 may also include components of a selection module 120 coupled to word-line electrode 110. Current-limiting circuitry 122 of selection module 120 may be coupled to word-line electrode 110 to facilitate a selection operation of one or more memory cells of memory cells 102 using word-line electrode 110. The selection operation may precede a read/write operation and place the targeted memory cell in a state to receive a read/write operation. During selection, a targeted memory cell may be moved from a sub-threshold region of operation to a region of operation above a threshold region of operation by applying a selection voltage bias across the targeted memory cell. The voltage bias to achieve selection of the targeted memory cell may be provided by word-line and bit-line driver circuitry (e.g., of the selection module 120) of the respective word-line and bit-line for the targeted memory cell in conjunction with current-limiting circuitry 122. Word-line and bit-line bias for the respective word-line and bit-line may be chosen such that, in combination, an overall voltage bias is applied across the targeted memory cell that is sufficient to bring the targeted memory cell above a threshold voltage (Vt). In the present example, "above Vt" may refer to a region of operation of a targeted memory cell that is capable of conducting sufficient current for a write operation, although a smaller current may maintain the targeted memory cell in the region of operation. The transition from sub-threshold to Vt or above a Vt region may involve a 'snap-back' event where the voltage sustained by the selected cell for a given current through the cell is suddenly reduced. As described more below, the 'snap-back' event or snap-detect may be utilized to read a state of a targeted memory cell prior to a refresh write operation to facilitate a validation of whether the refresh write operation successfully reset a Vt drift for the targeted memory cell. Current limiting circuitry 122 may limit the current of word-line electrode 110 to prevent damaging the selected memory cell with excessive current. That is, limiting the maximum current of word-line electrode 110 may also limit the maximum current through the memory cells 102. The limiting function may be ineffective during a time that word-line electrode 110 and a word-line decoding path of the target word-line are charging to a steady state. Examples are not limited to having current limiting circuitry 122 using a word-line electrode such as word-line electrode 110 to protect memory cells from excessive current. In other examples currently limiting circuitry 122 may use a bit-line electrode such as bit-line electrode 108 to protect memory cells from excessive current.

According to some examples, current-limiting circuitry 122 may be placed on whichever of word-line electrode 110 or bit-line electrode 108 that has a lower capacitance in order to reduce or minimize a transient current after snap-back of one or more memory cells 102 to a level that reduces damage or disturbance of memory cells 102. In the example shown in FIG. 1, current-limiting circuitry 122 is placed on word-line electrode 110.

In some examples, current-limiting circuitry 122 may include a current mirror circuit. Current-limiting circuitry 122 may include a transistor gate that is configured to limit a current of word-line electrode 110 to a maximum current level. For example, the transistor may be an n-type transistor having a gate that is controlled to an analog level such that the transistor delivers up to a maximum desired current. Current-limiting circuitry 122 may be enabled by applying a gate voltage to the transistor. Selection module 120 may include additional control circuitry to facilitate decoding of a target memory cell of the one or more memory cells 102 such that the targeted memory cell is moved from a subthreshold region of operation to a region of operation above Vt, where Vt is a function of current.

Although example types of memory included in system 100 have been described as including non-volatile types of memory such as PCM, this disclosure is not limited to PCM. In some examples, other types of resistive non-volatile memory included in a 3-D cross-point memory architecture that may be block or byte addressable are contemplated by this disclosure. These block or byte addressable resitive non-volatile types of memory may include, but are not limited to, single or multi-level phase change memory (PCM), nanowire memory, polymer memory, ferroelectric polymer memory, ferroelectric transistor random access memory (FeTRAM), ovonic memory, magnetoresistive random access memory (MRAM) that incorporates memristor technology, or spin transfer torque MRAM (STT-MRAM), or a combination of any of the above, or other resistive non-volatile memory types.

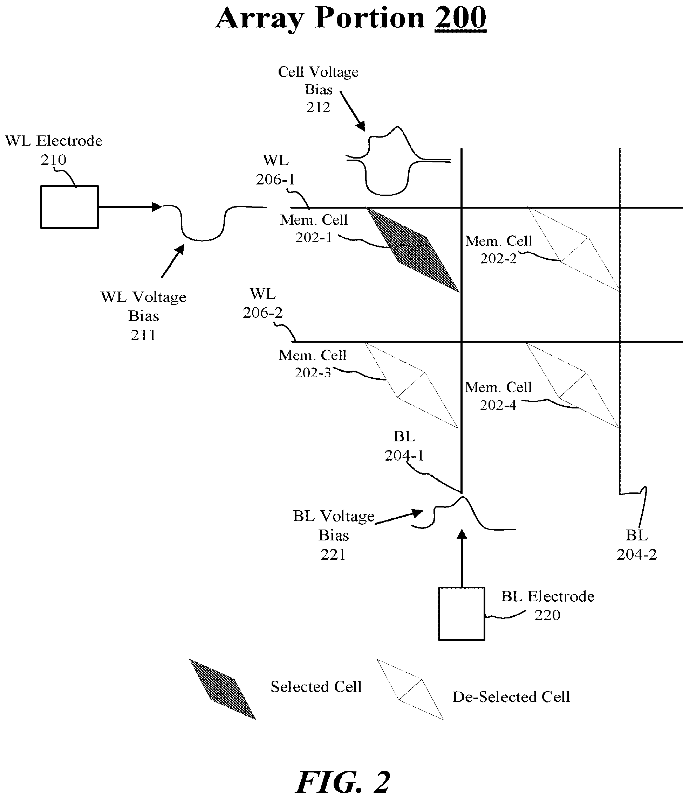

**FIG. 2** illustrates an example array portion 200. In some examples, array portion 200 as shown in FIG. 2, includes memory cells 202-1 to 202-4, bit-lines (BLs) 204-1, 204-2 and word-lines (WLs) 206-1, 206-2. Array portion 200 may have memory cells 202-1 to 202-4 arranged to be at intersections between WLs and BLs that may be metal lines used for access (write or read operations) to these memory cells. Similar to as described above for system 100, a targeted memory cell of memory cells 202-1 to 202-4 may be selected by applying a relevant voltage bias across one of WLs 206-1 or 206-2 and one of BLs 204-1 or 204-2 such that a total differential voltage across the targeted memory cell exceeds a Vt to select the targeted memory cell during an access. For example, during a write operation, bias voltages on a given WL of WLs 206-1 or 206-2 (e.g., provided by a WL electrode) or a given BL of BLs 204-1 or 204-2 (e.g., provided by a BL electrode) may be adjusted to allow for sufficient current to flow through the selected memory cell to program the selected memory cell into a correct state (e.g., SET or RESET).

According to some examples, shaded memory cell 202-1 may be a targeted memory cell for selection. As the targeted memory cell, memory cell 202-1 may receive a total bias voltage to deliver sufficient current and voltage to select and then program memory cell 202-1 during a write operation. As shown in FIG. 2, the total bias voltage may be delivered over WL 206-1 from WL electrode 210 that provides WL voltage bias 211 and over BL 204-1 from BL electrode 220 that provides BL voltage bias 221 to generate cell voltage bias 212 at memory cell 202-1 from a combination of WL voltage bias 211 and BL voltage bias 221. In some examples, WL voltage bias 211, as shown in FIG. 2, may be a negative voltage bias and BL voltage bias 221 may have a positive voltage bias. Unshaded memory cells 202-2, 202-3 and 202-4 may be de-selected memory cells. De-selected memory cell 202-2 on the same WL as targeted memory cell 202-1 may be referred to as an A-cell. De-selected memory cell 202-3 on the same BL as selected memory cell 202-1 may be referred to as a B-cell.

In some examples, WL voltage bias 211 and BL voltage bias 221, when taken separately, are both at sub-threshold voltage biases (e.g., below Vt). These sub-threshold voltage biases may vary in magnitude and duration depending on an operation being performed on a selected memory cell. Typically, a highest amount of voltage bias may be required for a type of write operation such as a RESET operation where a relatively larger amount of current may be required though a targeted memory cell that is selected for programming. A RESET operation, due to its need for a relatively larger amount of current, is more vulnerable to Vt drift overtime compared to a SET operation. For example, Vt drift overtime may exceed a maximum selection voltage bias. The maximum selection voltage bias may be based, at least in part, on an amount of voltage bias that may be applied to a targeted memory cell without damaging the memory cell and/or within programming time limits (e.g., dictated by capacitor charging times). As described more below, various mitigation schemes may be implemented to facilitate validation of refresh writes to determine whether Vt drift for one or more memory cells has been reset enough to reset Vt to a level below at least a maximum selection voltage bias for the one or more memory cells.

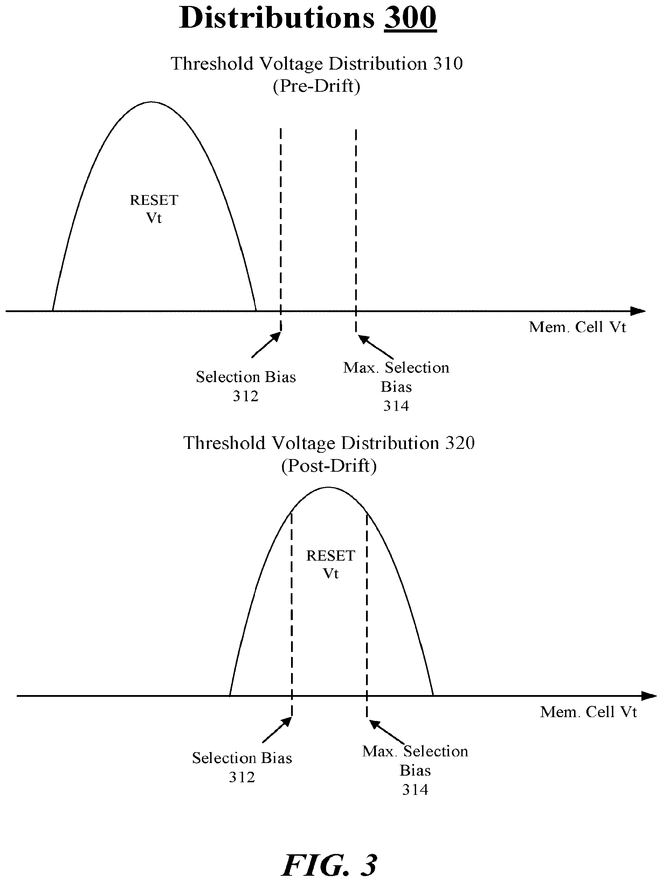

**FIG. 3** illustrates example distributions 300. In some examples, as shown in FIG. 3, distributions 300 includes a first threshold voltage distribution 310 (pre-drift) and a second threshold voltage distribution 320 (post-drift). For these examples, threshold voltage distribution 310 compared to threshold voltage distribution 320 may show Vt drift for memory cells that have been programmed via a RESET operation (e.g., to maintain a value of "0") that drift over a period of time (e.g., over a 48-hour period of time).

In some examples, as shown in FIG. 3, a selection bias 312 may be a lower selection voltage bias compared to a maximum selection bias 314. For these examples, the pre-drift threshold voltage distribution 310 may allow for either selection voltage bias to be used to select memory cells for a RESET operation. However, threshold voltage distribution 320 indicates that the Vt drift for the memory cells has caused threshold voltage distribution 320 to be greater than selection bias 312 for a large portion of memory cells and above maximum selection bias 314 for a smaller portion of memory cells. Thus, at least a portion of memory cells may be not be selected due to the Vt drift. In some examples, a simple refresh write operation to attempt to reset the Vt drift such that the memory cells threshold voltage distribution falls below or to the left of maximum selection bias 314 and/or selection bias 312 may not be successful because at least of portion of the memory cells may not be selected. This lack of ability to select at least a portion of the memory cells may eventually cause an unacceptably high number of memory cells to be unprogrammable and may lead to an unacceptable high level of bit errors as additional memory cells may have similar Vt drift profiles that cause these additional memory cells to also be unprogrammable.

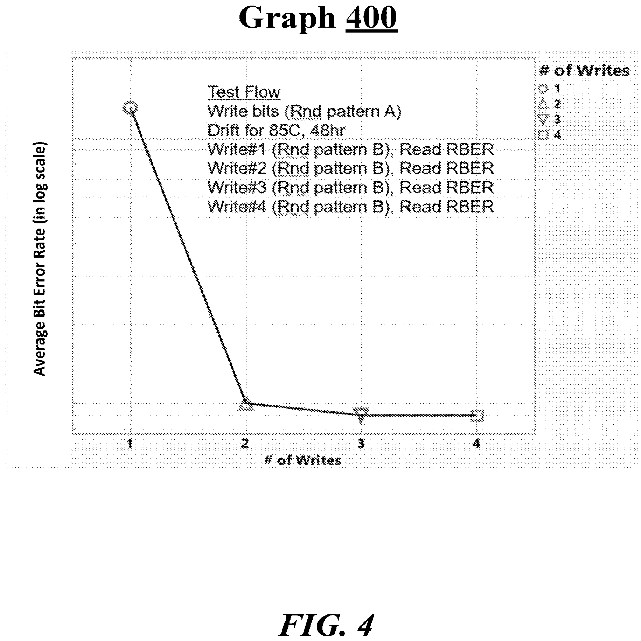

**FIG. 4** illustrates an example graph 400. In some examples, as shown in FIG. 4, graph 400 depicts how residual bit error rate (RBER) may be substantially reduced following a second refresh write operation after an initial write operation that occurred 48 hours prior and had an operating temperature of 85 degrees Celsius during that 48 hours. Graph 400 also depicts that more refresh write operations than 2 may slightly reduce RBER but with diminishing returns.

In some examples, a method may be implemented to perform two consecutive refresh write operations to correct for Vt drift and reduce RBER. However, performing two consecutive refresh write operations may consume twice the energy of a single refresh write and also may consume additional memory bandwidth to complete the extra refresh write operation. As described more below, various mitigation schemes may be implemented to attempt to first validate whether a memory cell has been selected to reset Vt drift and then only attempt a second refresh write if it was determined that the memory cell was not selected based on lack of detection of a 'snap-back' event.

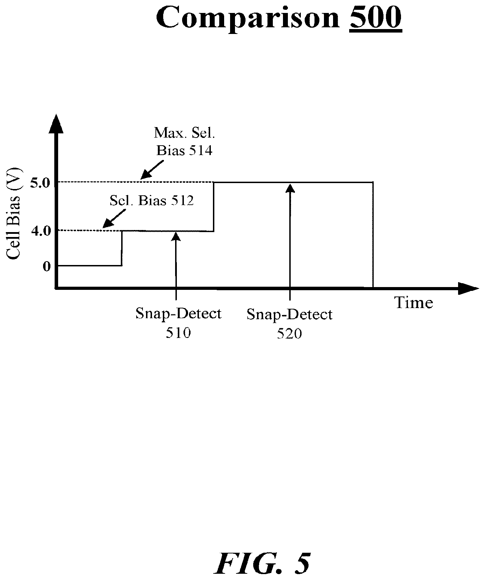

**FIG. 5** illustrates an example comparison 500. In some examples, as shown in FIG. 5, comparison 500 shows a comparison of memory cell bias in volts (V) for a selection bias 512 that is less than a maximum selection bias 514 for selecting a target memory cell for a refresh write operation. For these examples, the refresh write operation may be for a RESET operation and may be applied to 3-D cross-point memory architecture including PCM such as chalcogenide glass. As shown in FIG. 5, selection bias 512 may apply a cell bias voltage of around 4.0V while maximum selection bias 514 may apply a cell bias voltage of around 5.0V.

In some examples, as shown in FIG. 5, a snap-detect 510 may be utilized to determine whether selection bias 512 was sufficient enough to reach a Vt for a targeted memory cell. For example, sufficient cell bias voltage to bring the targeted memory cell to a level to conduct sufficient current for a RESET write operation. Selection bias 512 may be used if low power or low latency programing is needed to meet low power needs or tight timings requirements. However, using just a lower cell bias for selection bias 512 compared to maximum selection bias 514 may result in more selection failures for attempts to reset Vt drift compared to using maximum selection bias 514. These selection failures may increase RBER for a memory device.

According to some examples, as shown in FIG. 5, a snap-detect 520 may be utilized to determine whether maximum selection bias 514 was sufficient enough to reach a Vt for a targeted memory cell. Maximum selection bias 514 may be used if a goal is to minimize selection failures for attempts to reset Vt drift. However, maximum selection bias 514 may increase times to complete RESET write operations and use more power compared to selection bias 512. Hence a tradeoff exists between reducing power and latencies and reducing selection failures.

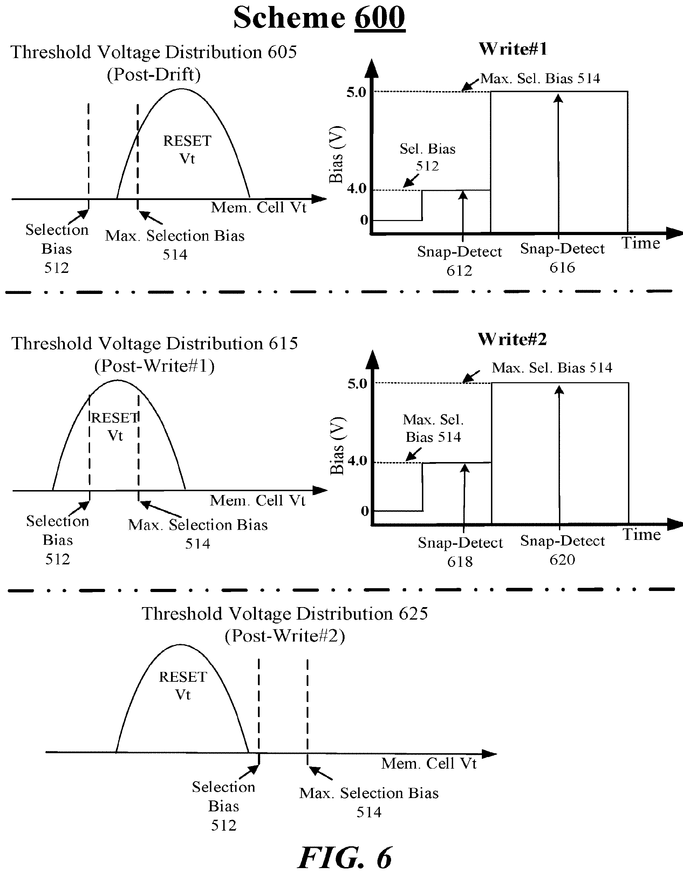

**FIG. 6** illustrates example scheme 600. In some examples, scheme 600 may incorporate use of selection bias 512 and maximum selection bias 514 for a first refresh write operation (write #1). For these examples, threshold voltage distribution 605 may represent a threshold voltage distribution of a resistive type of memory cells, post-drift. In other words, threshold voltage distribution 605 depicts a threshold voltage distribution for memory cell programmed with a RESET value after a time period. As shown in FIG. 6, threshold voltage distribution 605 may have a Vt drift that caused all of the memory cell's Vt to drift to a level that is greater than selection bias 512 and a large portion of the memory cell's Vt to even drift to a level that is greater than maximum selection bias 514. Although examples are not limited to any particular time period for threshold voltage distribution 605, the post-drift time period may be 48 hours, the beginning of which may start or set a 48-hour drift clock. In some examples, the post-drift time period may be more than or less than 48 hours based, at least in part, on how far Vts for memory cells may drift over time. High rates of Vt drift that could cause a threshold voltage distribution to drift significantly above selection bias 512 and maximum selection bias 514 may require shorter time periods (e.g., 24 hours). Also, low rates of Vt drift that could cause a threshold voltage distribution to drift such that it may still be below maximum selection bias 514 after 48 hours may use a longer time period (e.g., 72 hours).

According to some examples, scheme 600 may first use the lower selection bias 512 to attempt to select memory cells for a first refresh write operation. For these examples, because the memory cell's Vt for threshold voltage distribution 605 is greater than selection bias 512, snap-detect 612 will indicate that no memory cells had a snap-back event and thus the memory cells were not selected. Based on the lack of a detected snap-back event, maximum selection bias 514 may then be applied to the memory cells and a second snap-detect 616 may indicate at least a portion of the memory cells had a snap-back event but that a large portion did not have a snap-back event.

In some examples, scheme 600 may include use of a second refresh write operation. For these examples, threshold voltage distribution 615 depicts that the threshold voltage distribution has been shifted to the left due to the first refresh write operation, but not shifted enough to have threshold voltage distribution 615 fall below selection bias 512. If selection bias 512 is used for the second refresh write operation, then at least a portion of the memory cells would have a selection failure as detected by snap-detect 618. Based on the lack of a detected snap-back event for at least the portion of memory cells, maximum selection bias 514 may then be applied to the memory cells and a second snap-detect 620 may indicate a substantially larger portion of the memory cells (e.g., more than 99% of all memory cells receiving the refresh write operation) had a snap-back event. Detecting the 'snap-back' for a substantially larger portion of the memory cells at snap-detect 620 serves as a verification that selection was successful for an acceptable number of memory cells.

According to some examples, as shown in FIG. 6, threshold voltage distribution 625 may depict a threshold voltage distribution of the memory cell post-write #2. In other words, after the second refresh write operation. For these examples, threshold voltage distribution 625 has now been shifted to enable either selection bias 512 or maximum selection bias 514 to be used to select the memory cells for a refresh write operation. In some examples, the 48-hour drift clock may be reset or restarted to begin a new time period.

In some examples, a determination may be made on whether to implement the second RESET write operation for a plurality of memory cells if a threshold number of memory cells were not selected via use of selection bias 512 for the first refresh write operation. The threshold number may be based on an anticipated RBER if the number of memory cells are not successfully selected with selection bias 512 and need maximum selection bias 514 for successful selection. Therefore, the second refresh write operation may only be triggered based on the threshold number.

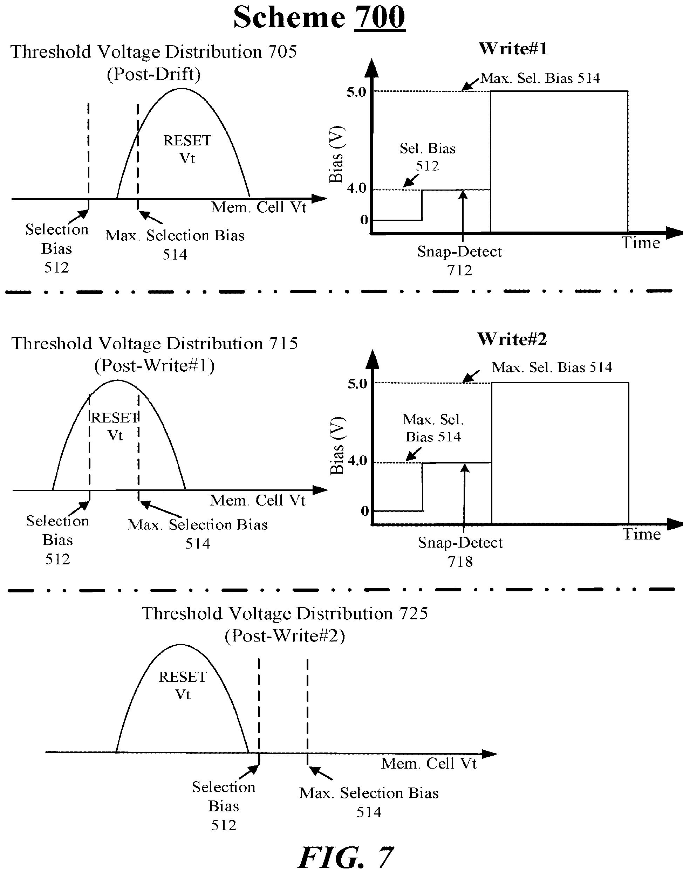

**FIG. 7** illustrates example scheme 700. In some examples, scheme 700 may incorporate use of selection bias 512 and maximum selection bias 514 for a first refresh write operation. For these examples, threshold voltage distribution 705 may represent a threshold voltage distribution of a resistive type of memory cells, post-drift. As shown in FIG. 7, threshold voltage distribution 705 may have a Vt drift that caused all of the memory cell's Vt to drift to a level that is greater than maximum selection bias 512 and a large portion of the memory cell's Vt to even drift to a level that is greater than maximum selection bias 514. Although examples are not limited to any particular time period for threshold voltage distribution 705, the post-drift time period may be 48 hours, the beginning of which may start or set a 48-hour drift clock. In some examples, the post-drift time period may be more than or less than 48 hours based, at least in part, on how far Vts for memory cells may drift over time. High rates of Vt drift that could cause a threshold voltage distribution to drift significantly above selection bias 512 and maximum selection bias 514 may require shorter time periods. Also, low rates of Vt drift that could cause a threshold voltage distribution to drift such that it may still be below selection bias 512 and maximum selection bias 514 after 48 hours may use a longer time period.

According to some examples, scheme 700 may first use the lower selection bias 512 to attempt to select memory cells for a first refresh write operation. For these examples, because the memory cell's Vt for threshold voltage distribution 705 is greater than maximum selection bias 512, snap-detect 712 will indicate that no memory cells had a snap-back event and thus the memory cells were not selected. Based on the lack of a detected snap-back event, maximum selection bias 514 may then be applied to the memory cells. However, scheme 700 differs from scheme 600 in that a second snap-detect is not implemented. Removing the second snap-detect may be an effort to save power (e.g., no need to power circuitry to latch a snap detect result) and more quickly complete the second refresh write operation. However, removing the second snap-detect may cause a tradeoff of having some uncertainty as to whether memory cells were selected when using maximum selection bias 514.

In some examples, scheme 700 may include use of a second refresh write operation. For these examples, threshold voltage distribution 715 depicts that the threshold voltage distribution has been shifted to the left due to the first refresh write operation, but still not shifted enough to have threshold voltage distribution 715 fall below selection bias 512. If selection bias 512 is used for the second refresh write operation, then at least a portion of the memory cells would have a selection failure as detected by snap-detect 718. Based on the lack of a detected snap-back event for at least the portion of memory cells, maximum selection bias 514 may then be applied to the memory cells without a second snap-detect to verify that the memory cells were selected.

According to some examples, as shown in FIG. 7, threshold voltage distribution 725 may depict a threshold voltage distribution of the memory cell post-write #2. In other words, after the second refresh write operation. For these examples, threshold voltage distribution 725 has now been shifted enough to enable either selection bias 512 or maximum selection bias 514 to be used to select the memory cells for a refresh write operation. In some examples, the 48-hour drift clock may be reset or restarted to begin a new time period.

In some examples, a determination may be made on whether to implement the second RESET write operation for a plurality of memory cells if a threshold number of memory cells were not selected via use of selection bias 512 for the first refresh write operation. The threshold number may be based on an anticipated RBER if the number of memory cells are not successfully selected with selection bias 512. Therefore, the second refresh write operation may only be triggered based on the threshold number.

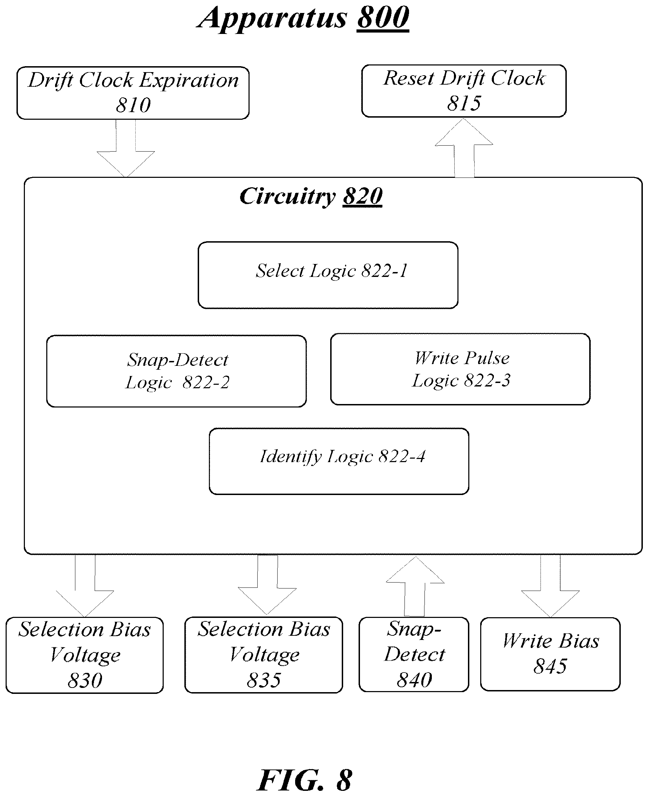

**FIG. 8** illustrates an example block diagram for an apparatus 800. Although apparatus 800 shown in FIG. 8 has a limited number of elements in a certain topology, it may be appreciated that the apparatus 800 may include more or less elements in alternate topologies as desired for a given implementation.

The apparatus 800 may be supported by circuitry 820 and apparatus 800 may be a controller maintained at a memory device or with a memory system coupled with memory cells of the memory device through an interface that may also be used to access the memory cells (e.g., via read or write operations). The memory device may be coupled with or included in a host computing platform. Circuitry 820 may be arranged to execute one or more software or firmware implemented logic, components or modules 822-*α* (e.g., implemented, at least in part, by a controller of a memory device). It is worthy to note that "*α*" and "*b*" and "*c*" and similar designators as used herein are intended to be variables representing any positive integer. Thus, for example, if an implementation sets a value for *α* = 4, then a complete set of software or firmware for logic, components or modules 822-*α* may include logic 822-1, 822-2, 822-3 or 822-4. Also, at least a portion of "logic" may be software/firmware stored in computer-readable media, or may be implemented, at least in part in hardware and although the logic is shown in FIG. 8 as discrete boxes, this does not limit logic to storage in distinct computer-readable media components (e.g., a separate memory, etc.) or implementation by distinct hardware components (e.g., separate application-specific integrated circuits (ASICs) or field programmable gate arrays (FPGAs)).

According to some examples, circuitry 820 may include a processor or processor circuitry. The processor or processor circuitry can be any of various commercially available processors, including without limitation an AMD^{®} Athlon^{®}, Duron^{®} and Opteron^{®} processors; ARM^{®} application, embedded and secure processors; IBM^{®} and Motorola^{®} DragonBall^{®} and PowerPC^{®} processors; IBM and Sony^{®} Cell processors; Intel^{®} Atom^{®}, Celeron^{®}, Core (2) Duo^{®}, Core i3, Core i5, Core i7, Itanium^{®}, Pentium^{®}, Xeon^{®}, Xeon Phi^{®} and XScale^{®} processors; and similar processors. According to some examples circuitry 820 may also include one or more ASICs or FPGAs and, in some examples, at least some logic 822-a may be implemented as hardware elements of these ASICs or FPGAs.

According to some examples, apparatus 800 may include a selection logic 822-1. Selection logic 822-1 may be a logic and/or feature executed by circuitry 820 to select a memory cell from among memory cells of a memory device for a first refresh write operation via application of a one or more selection bias voltages to the memory cell. For these examples, the selection of the memory cell and may be responsive to receiving an indication of expiration of a time period received via drift clock expiration 810. The one or more selection bias voltages may be applied to the memory cell via selection bias voltage 830.

In some examples, apparatus 800 may also include a snap-detect logic 822-2. Snap-detect logic 822-2 may be a logic and/or feature executed by circuitry 820 to determine whether the memory cell was selected for the first refresh write operation based on whether a snap-back event was detected for the memory cell while the one or more selection bias voltages were applied. For these examples, snap-detect 840 may include an indication of whether or not a 'snap-back' event was detected.

According to some examples, apparatus 800 may also include a write pulse logic 822-3. Write pulse logic 822-3 may be a logic and/or feature executed by circuitry 820 to cause a write pulse to be applied to the memory cell for the first refresh write operation. For these example, write bias 845 may include write bias voltage sufficient to cause the write pulse. If the first refresh write operation is a RESET write operation, for example, write bias 845 may include a RESET bias voltage of around 4.0V to 5.0V to cause a RESET write pulse.

In some examples, select logic 822-1 may select the memory cell for a second refresh write operation via re-application of the one or more selection bias voltages based on no detection of a snap-back event for the memory cell by snap-detect logic 822-2 during the first refresh write operation. For this second refresh write operation, the one or more selection bias voltages may be re-applied via selection bias voltage 835. Also, write pulse logic 822-3 may cause a second write pulse to be applied to the memory cell for the second refresh write operation.

According to some examples, snap-detect logic 822-2 may determine whether the memory cell was selected for the second refresh write operation based on whether a snap-back event was detected for the memory cell while the one or more selection bias voltages were re-applied. In some examples, apparatus 800 may also include an identify logic 822-4. Identify logic 822-4 may be a logic and/or feature executed by circuitry 820 to receive an indication from snap-detect logic 822-2 that the memory cell did not have a detected snap-back event following the second refresh write operation. Identify logic 822--4 may then identify the memory cell as having a Vt drift over the time period (e.g., over 48 hours) that causes a selection failure. For this example, the selection failure is based on no detection or lack of detection of the snap-back event for the memory cell by snap-detect logic 822-2 while the one or more selection bias voltages were re-applied.

In some examples, select logic 822-1 may cause a reset of the drift clock via reset drift clock 815 if snap-detect logic 822-2 detects a snap-back event for either the first or second refresh write operations. For example, if a snap-back event is detected for the first refresh write operation, the second refresh write operation may not be needed and the drift clock can be reset after the first refresh write operation. If a snap-back event is detected for the second refresh write operation, the memory cell is not identified by identify logic 822-4 as having an excessive Vt drift over the time period kept by the drift clock and thus the drift clock can be reset after the second refresh write operation.

Included herein is a set of logic flows representative of example methodologies for performing novel aspects of the disclosed architecture. While, for purposes of simplicity of explanation, the one or more methodologies shown herein are shown and described as a series of acts, those skilled in the art will understand and appreciate that the methodologies are not limited by the order of acts. Some acts may, in accordance therewith, occur in a different order and/or concurrently with other acts from that shown and described herein. For example, those skilled in the art will understand and appreciate that a methodology could alternatively be represented as a series of interrelated states or events, such as in a state diagram. Moreover, not all acts illustrated in a methodology may be required for a novel implementation.

A logic flow may be implemented in software, firmware, and/or hardware. In software and firmware embodiments, a logic flow may be implemented by computer executable instructions stored on at least one non-transitory computer readable medium or machine readable medium, such as an optical, magnetic or semiconductor storage. The embodiments are not limited in this context.

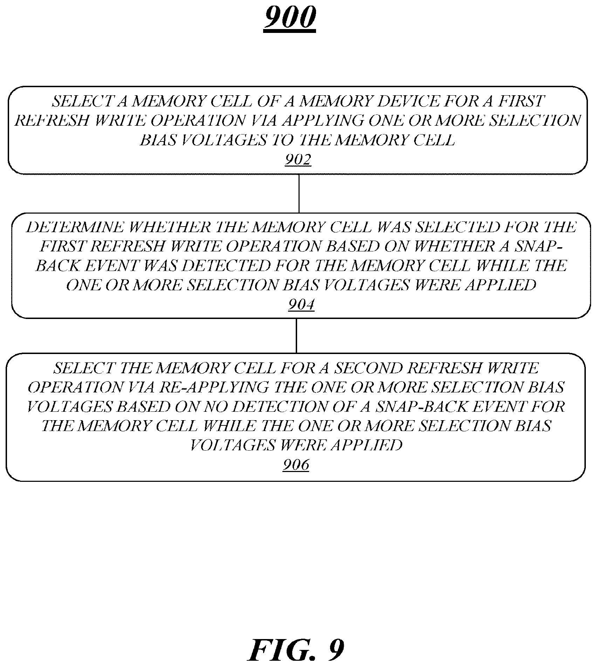

**FIG. 9** illustrates an example of a logic flow 900. Logic flow 900 may be representative of some or all of the operations executed by one or more logic, features, or devices described herein, such as apparatus 800. More particularly, logic flow 900 may be implemented by one or more of selection logic 822-1, snap-detect logic 822-2, write pulse logic 822-3 or identify logic 822-4.

According to some examples, logic flow 900 at block 902 may select a memory cell of a memory device for a first refresh write operation via applying one or more selection bias voltages to the memory cell. For these examples, selection logic 822-1 may select the memory cell.

In some examples, logic flow 900 at block 904 may determine whether the memory cell was selected for the first refresh write operation based on whether a snap-back event was detected for the memory cell while the one or more selection bias voltages were applied. For these examples, snap-detect logic 822-2 may determine whether the memory cell was selected based on whether a snap-back event was detected.

According to some examples, logic flow 900 at block 906 may select the memory cell for a second refresh write operation via re-applying the one or more selection bias voltages based on no detection of a snap-back event for the memory cell while the one or more selection bias voltages were applied. For these examples, select logic 822-1 may cause the one or more selection bias voltages to be re-applied based on an indication from snap-detect logic 822-2 that no snap-back event was detected.

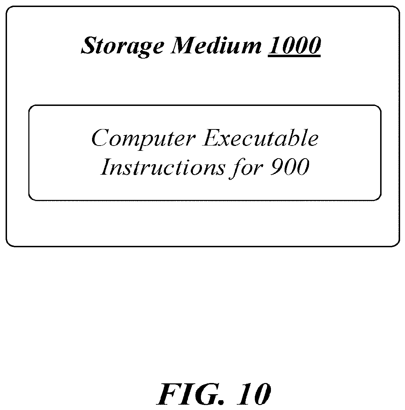

**FIG. 10** illustrates an example of a first storage medium. As shown in FIG. 10, the first storage medium includes a storage medium 1000. The storage medium 1000 may comprise an article of manufacture. In some examples, storage medium 1000 may include any non-transitory computer readable medium or machine readable medium, such as an optical, magnetic or semiconductor storage. Storage medium 1000 may store various types of computer executable instructions, such as instructions to implement logic flow 900. Examples of a computer readable or machine readable storage medium may include any tangible media capable of storing electronic data, including volatile memory or non-volatile memory, removable or non-removable memory, erasable or non-erasable memory, writeable or re-writeable memory, and so forth. Examples of computer executable instructions may include any suitable type of code, such as source code, compiled code, interpreted code, executable code, static code, dynamic code, object-oriented code, visual code, and the like. The examples are not limited in this context.

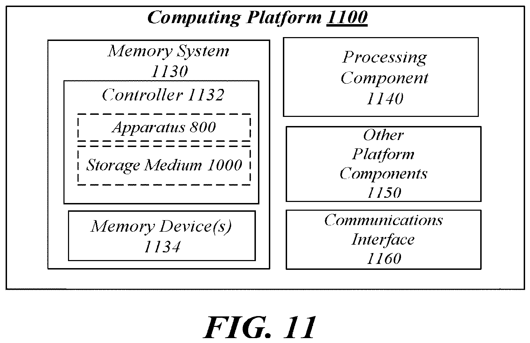

**FIG. 11** illustrates an example computing platform 1100. In some examples, as shown in FIG. 11, computing platform 1100 may include a memory system 1130, a processing component 1140, other platform components 1150 or a communications interface 1160. According to some examples, computing platform 1100 may be implemented in a computing device.

According to some examples, memory system 1130 may include a controller 1132 and memory devices(s) 1134. For these examples, logic and/or features resident at or located at controller 1132 may execute at least some processing operations or logic for apparatus 800 and may include storage media that includes storage medium 1000. Also, memory device(s) 1134 may include similar types of non-volatile memory (not shown) that are described above for system 100 or array portion 200 shown in FIGS. 1 and 2. In some examples, controller 1132 may be part of a same die with memory device(s) 1134. In other examples, controller 1132 and memory device(s) 1134 may be located on a same die or integrated circuit with a processor (e.g., included in processing component 1140). In yet other examples, controller 1132 may be in a separate die or integrated circuit coupled with memory device(s) 1134.

According to some examples, processing component 1140 may include various hardware elements, software elements, or a combination of both. Examples of hardware elements may include devices, logic devices, components, processors, microprocessors, circuits, processor circuits, circuit elements (e.g., transistors, resistors, capacitors, inductors, and so forth), integrated circuits, ASIC, programmable logic devices (PLD), digital signal processors (DSP), FPGA/programmable logic, memory units, logic gates, registers, semiconductor device, chips, microchips, chip sets, and so forth. Examples of software elements may include software components, programs, applications, computer programs, application programs, system programs, software development programs, machine programs, operating system software, middleware, firmware, software modules, routines, subroutines, functions, methods, procedures, software interfaces, APIs, instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given example.

In some examples, other platform components 1150 may include common computing elements, such as one or more processors, multi-core processors, co-processors, memory units, chipsets, controllers, peripherals, interfaces, oscillators, timing devices, video cards, audio cards, multimedia I/O components (e.g., digital displays), power supplies, and so forth. Examples of memory units associated with either other platform components 1150 or storage system 1130 may include without limitation, various types of computer readable and machine readable storage media in the form of one or more higher speed memory units, such as read-only memory (ROM), RAM, DRAM, DDR DRAM, synchronous DRAM (SDRAM), DDR SDRAM, SRAM, programmable ROM (PROM), EPROM, EEPROM, flash memory, ferroelectric memory, SONOS memory, polymer memory such as ferroelectric polymer memory, nanowire, FeTRAM or FeRAM, ovonic memory, phase change memory, memristers, STT-MRAM, magnetic or optical cards, and any other type of storage media suitable for storing information.

In some examples, communications interface 1160 may include logic and/or features to support a communication interface. For these examples, communications interface 1160 may include one or more communication interfaces that operate according to various communication protocols or standards to communicate over direct or network communication links. Direct communications may occur through a direct interface via use of communication protocols or standards described in one or more industry standards (including progenies and variants) such as those associated with the SMBus specification, the PCIe specification, the NVMe specification, the SATA specification, SAS specification or the USB specification. Network communications may occur through a network interface via use of communication protocols or standards such as those described in one or more Ethernet standards promulgated by the IEEE. For example, one such Ethernet standard may include IEEE 802.3-2012, Carrier sense Multiple access with Collision Detection (CSMA/CD) Access Method and Physical Layer Specifications, Published in December 2011 (hereinafter "IEEE 802.3").

Computing platform 1100 may be part of a computing device that may be, for example, user equipment, a computer, a personal computer (PC), a desktop computer, a laptop computer, a notebook computer, a netbook computer, a tablet, a smart phone, embedded electronics, a gaming console, a server, a server array or server farm, a web server, a network server, an Internet server, a work station, a mini-computer, a main frame computer, a supercomputer, a network appliance, a web appliance, a distributed computing system, multiprocessor systems, processor-based systems, or combination thereof. Accordingly, functions and/or specific configurations of computing platform 1100 described herein, may be included or omitted in various embodiments of computing platform 1100, as suitably desired.

The components and features of computing platform 1100 may be implemented using any combination of discrete circuitry, ASICs, logic gates and/or single chip architectures. Further, the features of computing platform 1100 may be implemented using microcontrollers, programmable logic arrays and/or microprocessors or any combination of the foregoing where suitably appropriate. It is noted that hardware, firmware and/or software elements may be collectively or individually referred to herein as "logic", "circuit" or "circuitry."

Although not depicted, any system can include and use a power supply such as but not limited to a battery, AC-DC converter at least to receive alternating current and supply direct current, renewable energy source (e.g., solar power or motion based power), or the like.

One or more aspects of at least one example may be implemented by representative instructions stored on at least one machine-readable medium which represents various logic within the processor, which when read by a machine, computing device or system causes the machine, computing device or system to fabricate logic to perform the techniques described herein. Such representations may be stored on a tangible, machine readable medium and supplied to various customers or manufacturing facilities to load into the fabrication machines that actually make the logic or processor.

Various examples may be implemented using hardware elements, software elements, or a combination of both. In some examples, hardware elements may include devices, components, processors, microprocessors, circuits, circuit elements (e.g., transistors, resistors, capacitors, inductors, and so forth), integrated circuits, ASICs, PLDs, DSPs, FPGAs, memory units, logic gates, registers, semiconductor device, chips, microchips, chip sets, and so forth. In some examples, software elements may include software components, programs, applications, computer programs, application programs, system programs, machine programs, operating system software, middleware, firmware, software modules, routines, subroutines, functions, methods, procedures, software interfaces, APIs, instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given implementation.

Some examples may include an article of manufacture or at least one computer-readable medium. A computer-readable medium may include a non-transitory storage medium to store logic. In some examples, the non-transitory storage medium may include one or more types of computer-readable storage media capable of storing electronic data, including volatile memory or non-volatile memory, removable or non-removable memory, erasable or non-erasable memory, writeable or re-writeable memory, and so forth. In some examples, the logic may include various software elements, such as software components, programs, applications, computer programs, application programs, system programs, machine programs, operating system software, middleware, firmware, software modules, routines, subroutines, functions, methods, procedures, software interfaces, API, instruction sets, computing code, computer code, code segments, computer code segments, words, values, symbols, or any combination thereof.

According to some examples, a computer-readable medium may include a non-transitory storage medium to store or maintain instructions that when executed by a machine, computing device or system, cause the machine, computing device or system to perform methods and/or operations in accordance with the described examples. The instructions may include any suitable type of code, such as source code, compiled code, interpreted code, executable code, static code, dynamic code, and the like. The instructions may be implemented according to a predefined computer language, manner or syntax, for instructing a machine, computing device or system to perform a certain function. The instructions may be implemented using any suitable high-level, low-level, object-oriented, visual, compiled and/or interpreted programming language.

Some examples may be described using the expression "in one example" or "an example" along with their derivatives. These terms mean that a particular feature, structure, or characteristic described in connection with the example is included in at least one example. The appearances of the phrase "in one example" in various places in the specification are not necessarily all referring to the same example.

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, but yet still co-operate or interact with each other.
In the foregoing Detailed Description, it can be seen that various features are grouped together in a single example for the purpose of streamlining the disclosure. This method of disclosure is not to be interpreted as reflecting an intention that the claimed examples require more features than are expressly recited in each claim. Rather, as the following claims reflect, inventive subject matter lies in less than all features of a single disclosed example. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. An apparatus comprising:
an interface to access resistive non-volatile memory cells (102) of a memory device (100); and
a controller (820) for the memory device, the controller to include logic (822-1), at least a portion of which is implemented as hardware, the logic being configured to:
select a memory cell from among the memory cells and perform a first refresh write operation on said selected memory cell via application of one or more selection bias voltages to the memory cell (902);
**characterised in that** the logic is further configured to :
determine whether the memory cell was selected and the first refresh write operation was performed based on whether a snap-back event (822-2) was detected for the memory cell while the one or more selection bias voltages were applied (904); and
select the memory cell and perform a second refresh write operation on said selected memory cell via re-application of the one or more selection bias voltages based on no detection of a snap-back event for said memory cell while the one or more selection bias voltages were applied (906).

2. The apparatus of claim 1, comprising the logic (822-1) to select the memory cell for the first refresh write operation responsive to expiration of a time period.

3. The apparatus of claim 2, the time period comprising 48 hours.

4. The apparatus of claim 2, further comprising the logic (822-1) to:
determine whether the memory cell (102) was selected and
the second refresh write operation was performed based on whether a snap-back event was detected for the memory cell while the one or more selection bias voltages were re-applied (906); and
identify the memory cell as having a voltage threshold drift over the time period that causes a selection failure based on no detection of a snap-back event for the memory cell while the one or more selection bias voltages were re-applied.

5. The apparatus of claim 1, the first and second refresh write operations comprising RESET write operations (700).

6. The apparatus of claim 1, the one or more selection bias voltages comprising a first selection bias voltage that is a highest selection bias voltage to select the memory cell for a refresh write operation within a programming time limit and a second selection bias voltage that is less than the highest selection bias voltage (500).

7. The apparatus of claim 1, wherein the non-volatile memory cell (102) comprises phase change memory that uses chalcogenide phase change material, ferroelectric memory, memory, polymer memory, ferroelectric polymer memory, ferroelectric transistor random access memory (FeTRAM or FeRAM), ovonic memory, nanowire memory, magnetoresistive random access memory (MRAM) or spin transfer torque MRAM (STT-MRAM).

8. The apparatus of claim 1, comprising one or more of:
one or more processors (1140) communicatively coupled to the controller (1132);
a network interface (1160) communicatively coupled to the apparatus;
a battery coupled to the apparatus (1100); or
a display communicatively coupled to the apparatus (1100).

9. A method comprising:
selecting a resistive non-volatile memory cell (102) of a memory device (100) and perform a first refresh write operation on said memory cell via applying one or more selection bias voltages to the memory cell (902); **characterised in that** the method is further comprising :
determining whether said memory cell was selected and the first refresh write operation was performed based on whether a snap-back event (822-2) was detected for the memory cell while the one or more selection bias voltages were applied (904); and
selecting said memory cell and perform a second refresh write operation on said memory cell via re-applying the one or more selection bias voltages based on no detection of a snap-back event for the memory cell while the one or more selection bias voltages were applied (906).

10. The method of claim 9, comprising selecting the memory cell (102) for the first refresh write operation (902) responsive to expiration of a time period.

11. The method of claim 10, further comprising:
determining whether the memory cell (102) was selected and
the second refresh write operation was performed based on whether a snap-back event was detected for the memory cell while the one or more selection bias voltages were re-applied (906); and
identifying the memory cell as having a voltage threshold drift over the time period that causes a selection failure based on no detection of a snap-back event for the memory cell while the one or more selection bias voltages were re-applied.

12. The method of claim 9, the first and second refresh write operations comprising RESET write operations (700).

13. The method of claim 9, the one or more selection bias voltages comprising a first selection bias voltage that is a highest selection bias voltage to select the memory cell for a refresh write operation within a programming time limit and a second selection bias voltage that is less than the highest selection bias voltage (500).

14. A machine readable medium (1130) comprising a plurality of instructions that in response to being executed by a system (1100) cause the system to carry out the method according to any one of claims 9 to 13.

15. The apparatus of claim 1, further comprising the logic (1160) to : select memory cells from among the plurality of memory cells and perform a first refresh write operation on said selected memory cells via application of one or more selection bias voltages to the memory cells (902); determine whether the memory cells were selected and the first refresh write operation was performed based on whether respective snap-back events were detected for the memory cells while the one or more selection bias voltages were applied (904); and select the memory cells and perform a second refresh write operation on said selected memory cells via re-application of the one or more selection bias voltages based on no detection of a snap-back event for at least a portion of said memory cells while the one or more selection bias voltages were applied (906).

16. The apparatus of claim 15, comprising the logic to select at least a portion of the memory cells based on an anticipated value for a residual bit error rate (RBER) (400) for the memory device caused by a selection failure of the at least a portion of the memory cells.

17. The apparatus of claim 16, comprising the logic (1160) to select the memory cells for the first refresh write operation (902) responsive to expiration of a time period.

18. The apparatus of claim 17, the time period comprising 48 hours.

19. The apparatus of claim 17, further comprising the logic (1160) to:
determine whether the memory cells were selected and the second refresh write operation was performed based on whether a snap-back event was detected for the at least portion of the memory cells while the one or more selection bias voltages were re-applied (904); and
identify each memory cell from among the at least a portion of the memory cells as having a voltage threshold drift over the time period that causes a selection failure based on no detection of a snap-back event while the one or more selection bias voltages were re-applied (906).

20. The apparatus of claim 15, the one or more selection bias voltages comprising a first selection bias voltage that is a highest selection bias voltage to select the memory cells for a refresh write operation within a programming time limit and a second selection bias voltage that is less than the highest selection bias voltage (500).

21. The apparatus of claim 15, wherein the non-volatile memory cells (102) include phase change memory that uses chalcogenide phase change material, ferroelectric memory, memory, polymer memory, ferroelectric polymer memory, ferroelectric transistor random access memory (FeTRAM or FeRAM), ovonic memory, nanowire memory, magnetoresistive random access memory (MRAM) or spin transfer torque MRAM (STT-MRAM).

## Patentansprüche

1. Vorrichtung, umfassend:
eine Schnittstelle zum Zugreifen auf resistive nichtflüchtige Speicherzellen (102) eines Speicherbauelements (100); und
einen Controller (820) für das Speicherbauelement, wobei der Controller eine Logik (822-1) enthalten soll, wovon mindestens ein Abschnitt als Hardware implementiert ist,
wobei die Logik ausgelegt ist zum:
Wählen einer Speicherzelle unter den Speicherzellen und Durchführen einer ersten Auffrisch-Schreiboperation an der gewählten Speicherzelle über das Anlegen einer oder mehrerer Wahlvorspannungen an die Speicherzelle (902);
**dadurch gekennzeichnet, dass** die Logik weiter ausgelegt ist zum:
Bestimmen, ob die Speicherzelle gewählt wurde und die erste Auffrisch-Schreiboperation durchgeführt wurde auf Basis dessen, ob ein Snap-Back-Ereignis (822-2) für die Speicherzelle detektiert wurde, während die eine oder mehreren Wahlvorspannungen angelegt wurden (904); und Wählen der Speicherzelle und Durchführen einer zweiten Auffrisch-Schreiboperation an der gewählten Speicherzelle über Neuanlegung der einen oder mehreren Wahlvorspannungen auf Basis keiner Detektion eines Snap-Back-Ereignisses für die Speicherzelle, während die eine oder mehreren Wahlvorspannungen angelegt wurden (906).

2. Vorrichtung nach Anspruch 1, umfassend die Logik (822-1) zum Wählen der Speicherzelle für die erste Auffrisch-Schreiboperation als Reaktion auf den Ablauf einer Zeitperiode.

3. Vorrichtung nach Anspruch 2, wobei die Zeitperiode 48 Stunden umfasst.

4. Vorrichtung nach Anspruch 2, weiter umfassend die Logik (822-1) zum:
Bestimmen, ob die Speicherzelle (102) gewählt wurde und die zweite Auffrisch-Schreiboperation durchgeführt wurde auf Basis dessen, ob ein Snap-Back-Ereignis für die Speicherzelle detektiert wurde, während die eine oder mehreren Wahlvorspannungen erneut angelegt wurden (906); und
Identifizieren der Speicherzelle als über die Zeitperiode eine Spannungsschwellwertdrift aufweisend, die einen Auswahlfehler auf Basis von keiner Detektion eines Snap-Back-Ereignisses für die Speicherzelle bewirkt, während die eine oder mehreren Wahlvorspannungen erneut angelegt wurden.

5. Vorrichtung nach Anspruch 1, wobei die erste und zweite Auffrisch-Schreiboperation RESET-Schreiboperationen (700) umfassen.

6. Vorrichtung nach Anspruch 1, wobei die eine oder mehreren Wahlvorspannungen eine erste Wahlvorspannung umfassen, die eine höchste Wahlvorspannung ist zum Wählen der Speicherzelle für eine Auffrisch-Schreiboperation innerhalb einer Programmierzeitgrenze, und einer zweiten Wahlvorspannung, die unter der höchsten Wahlvorspannung (500) liegt.

7. Vorrichtung nach Anspruch 1, wobei die nichtflüchtige Speicherzelle (102) einen Phasenwechselspeicher umfasst, der ein Chalkogenid-Phasenwechselmaterial verwendet, einen ferroelektrischen Speicher, einen Speicher, einen Polymerspeicher, einen ferroelektrischen Polymerspeicher, einen ferroelektrischen Transistordirektzugriffsspeicher (FeTRAM oder FeRAM), einen ovonischen Speicher, einen Nanodrahtspeicher, einen magnetoresistiven Direktzugriffsspeicher (MRAM) oder einen Spin-Transfer-Torque-MRAM (STT-MRAM).

8. Vorrichtung nach Anspruch 1, umfassend einen oder mehrere von:
einem oder mehreren Prozessoren (1140), kommunikativ an den Controller (1132) gekoppelt;
einer Netzwerkschnittstelle (1160), kommunikativ an die Vorrichtung gekoppelt;
einer Batterie, an die Vorrichtung (1100) gekoppelt; oder
einem Display, kommunikativ an die Vorrichtung (1100) gekoppelt.

9. Verfahren, umfassend:
Wählen einer resistiven nichtflüchtigen Speicherzelle (102) eines Speicherbauelements (100) und Durchführen einer ersten Auffrisch-Schreiboperation an der Speicherzelle über das Anlegen einer oder mehrerer Wahlvorspannungen an die Speicherzelle (902);
**dadurch gekennzeichnet, dass** das Verfahren weiter umfasst:
Bestimmen, ob die Speicherzelle gewählt wurde und die erste Auffrisch-Schreiboperation durchgeführt wurde auf Basis dessen, ob ein Snap-Back-Ereignis (822-2) für die Speicherzelle detektiert wurde, während die eine oder mehreren Wahlvorspannungen angelegt wurden (904); und
Wählen der Speicherzelle und Durchführen einer zweiten Auffrisch-Schreiboperation an der gewählten Speicherzelle über Neuanlegung der einen oder mehreren Wahlvorspannungen auf Basis keiner Detektion eines Snap-Back-Ereignisses für die Speicherzelle, während die eine oder mehreren Wahlvorspannungen angelegt wurden (906).

10. Verfahren nach Anspruch 9, umfassend das Wählen der Speicherzelle (102) für die erste Auffrisch-Schreiboperation (902) als Reaktion auf den Ablauf einer Zeitperiode.

11. Verfahren nach Anspruch 10, weiter umfassend:
Bestimmen, ob die Speicherzelle (102) gewählt wurde und die zweite Auffrisch-Schreiboperation durchgeführt wurde auf Basis dessen, ob ein Snap-Back-Ereignis für die Speicherzelle detektiert wurde, während die eine oder mehreren Wahlvorspannungen erneut angelegt wurden (906); und
Identifizieren der Speicherzelle als über die Zeitperiode eine Spannungsschwellwertdrift aufweisend, die einen Auswahlfehler auf Basis von keiner Detektion eines Snap-Back-Ereignisses für die Speicherzelle bewirkt, während die eine oder mehreren Wahlvorspannungen erneut angelegt wurden.

12. Verfahren nach Anspruch 9, wobei die erste und zweite Auffrisch-Schreiboperation RESET-Schreiboperationen (700) umfassen.

13. Verfahren nach Anspruch 9, wobei die eine oder mehreren Wahlvorspannungen eine erste Wahlvorspannung umfassen, die eine höchste Wahlvorspannung ist zum Wählen der Speicherzelle für eine Auffrisch-Schreiboperation innerhalb einer Programmierzeitgrenze, und einer zweiten Wahlvorspannung, die unter der höchsten Wahlvorspannung (500) liegt.

14. Maschinenlesbares Medium (1130), umfassend mehrere Anweisungen, die als Reaktion auf das Ausführen durch ein System (1100) bewirken, dass das System das Verfahren nach einem der Ansprüche 9 bis 13 ausführt.

15. Vorrichtung nach Anspruch 1, weiter umfassend die Logik (1160) zum:
Wählen von Speicherzellen unter den mehreren Speicherzellen und Durchführen einer ersten Auffrisch-Schreiboperation an den gewählten Speicherzellen über das Anlegen einer oder mehrerer Wahlvorspannungen an die Speicherzelle (902);
Bestimmen, ob die Speicherzellen gewählt wurden und die erste Auffrisch-Schreiboperation durchgeführt wurde auf Basis dessen, ob jeweilige Snap-Back-Ereignisse für die Speicherzelle detektiert wurden, während die eine oder mehreren Wahlvorspannungen angelegt wurden (904); und
Wählen der Speicherzellen und Durchführen einer zweiten Auffrisch-Schreiboperation an den gewählten Speicherzellen über Neuanlegung der einen oder mehreren Wahlvorspannungen auf Basis keiner Detektion eines Snap-Back-Ereignisses für mindestens einen Abschnitt der Speicherzellen, während die eine oder mehreren Wahlvorspannungen angelegt wurden (906).

16. Vorrichtung nach Anspruch 15, umfassend die Logik zum Wählen mindestens eines Abschnitts der Speicherzellen auf Basis eines erwarteten Werts für eine Restbitfehlerrate (RBER) (400) für das Speicherbauelement verursacht durch einen Auswahlfehler des mindestens einen Abschnitts der Speicherzellen.

17. Vorrichtung nach Anspruch 16, umfassend die Logik (1160) zum Wählen der Speicherzellen für die erste Auffrisch-Schreiboperation (902) als Reaktion auf den Ablauf einer Zeitperiode.

18. Vorrichtung nach Anspruch 17, wobei die Zeitperiode 48 Stunden umfasst.

19. Vorrichtung nach Anspruch 17, weiter umfassend die Logik (1160) zum:
Bestimmen, ob die Speicherzellen gewählt wurden und die zweite Auffrisch-Schreiboperation durchgeführt wurde auf Basis dessen, ob ein Snap-Back-Ereignis für den mindestens Abschnitt der Speicherzellen detektiert wurde, während die eine oder mehreren Wahlvorspannungen wieder angelegt wurden (904); und
Identifizieren jeder Speicherzelle unter dem mindestens einen Abschnitt der Speicherzellen als über die Zeitperiode eine Spannungsschwellwertdrift aufweisend, auf Basis keiner Detektion eines Snap-Back-Ereignisses, während die eine oder mehreren Wahlvorspannungen wieder angelegt wurden (906).

20. Vorrichtung nach Anspruch 15,
wobei die eine oder mehreren Wahlvorspannungen eine erste Wahlvorspannung umfassen, die die höchste Wahlvorspannung ist, zum Wählen der Speicherzellen für eine Auffrisch-Schreiboperation innerhalb einer Programmierzeitgrenze, und eine zweite Wahlvorspannung, die unter der höchsten Wahlvorspannung (500) liegt.

21. Vorrichtung nach Anspruch 15,
wobei die nichtflüchtigen Speicherzellen (102) einen Phasenwechselspeicher beinhalten, der ein Chalkogenid-Phasenwechselmaterial verwendet, einen ferroelektrischen Speicher, einen Speicher, einen Polymerspeicher, einen ferroelektrischen Polymerspeicher, einen ferroelektrischen Transistordirektzugriffsspeicher (FeTRAM oder FeRAM), einen ovonischen Speicher, einen Nanodrahtspeicher, einen magnetoresistiven Direktzugriffsspeicher (MRAM) oder einen Spin-Transfer-Torque-MRAM (STT-MRAM).

## Revendications

1. Appareil comprenant :
une interface permettant d'accéder à des cellules de mémoire non volatile résistive (102) d'un composant mémoire (100), et
un contrôleur (820) pour le composant mémoire, le contrôleur incluant une logique (822-1) dont au moins une partie est mise en œuvre sous forme matérielle,
la logique étant configurée pour :
sélectionner une cellule de mémoire parmi les cellules de mémoire et effectuer une première opération d'écriture de rafraîchissement sur ladite cellule de mémoire sélectionnée par l'intermédiaire de l'application d'une ou plusieurs tensions de polarisation sur la cellule de mémoire (902),
**caractérisé en ce que** la logique est en outre configurée pour :
déterminer si la cellule de mémoire a été sélectionnée et si la première opération d'écriture de rafraîchissement a été effectuée sur la base de ce qu'un événement de « snap-back » (822-2) a été détecté pour la cellule de mémoire alors que la ou les tensions de polarisation de sélection étaient appliquées (904), et
sélectionner la cellule de mémoire et effectuer une seconde opération d'écriture de rafraîchissement sur ladite cellule de mémoire sélectionnée par l'intermédiaire d'une nouvelle application de la ou des tensions de polarisation sur la base de l'absence de détection d'un événement de snap-back pour ladite cellule de mémoire alors que la ou les tensions de polarisation de sélection étaient appliquées (906) .

2. Appareil selon la revendication 1, comprenant la logique (822-1) permettant de sélectionner la cellule de mémoire pour la première opération d'écriture de rafraîchissement en réponse à l'expiration d'un intervalle de temps.

3. Appareil selon la revendication 2, l'intervalle de temps comportant 48 heures.

4. Appareil selon la revendication 2, comprenant en outre la logique (822-1) permettant de :
déterminer si la cellule de mémoire (102) a été sélectionnée et si la seconde opération d'écriture de rafraîchissement a été effectuée sur la base de ce qu'un événement de snap-back a été détecté pour la cellule de mémoire alors que la ou les tensions de polarisation de sélection ont été appliquées de nouveau (906), et
identifier la cellule de mémoire comme présentant un seuil de dérive de tension sur l'intervalle de temps, lequel provoque une défaillance de sélection sur la base de l'absence de détection d'un événement de snap-back pour la cellule de mémoire alors que la ou les tensions de polarisation de sélection ont été appliquées de nouveau.

5. Appareil selon la revendication 1, dans lequel les première et seconde opérations d'écriture de rafraîchissement comprennent des opérations d'écriture de réinitialisation (700).

6. Appareil selon la revendication 1, dans lequel la ou les tensions de polarisation de sélection comprennent une première tension de polarisation de sélection, qui représente la tension la plus élevée de polarisation de sélection pour sélectionner la cellule de mémoire pour une opération d'écriture de rafraîchissement dans une limite de temps de programmation, ainsi qu'une seconde tension de polarisation de sélection qui est inférieure à la tension la plus élevée de polarisation de sélection (500) .

7. Appareil selon la revendication 1, dans lequel la cellule de mémoire non volatile (102) comprend une mémoire à changement de phase qui utilise un matériau de changement de phase à chalcogénure, une mémoire ferroélectrique, une mémoire, une mémoire à polymère, une mémoire à polymère ferroélectrique, une mémoire à accès direct à transistors ferroélectriques (FeTRAM ou FeRAM), une mémoire ovonique, une mémoire à nano fils, une mémoire à accès direct magnéto résistive (MRAM) ou une mémoire MRAM à couple de transfert de spin (STT-MRAM) .

8. Appareil selon la revendication 1, comprenant un ou plusieurs parmi :
un ou plusieurs processeurs (1140) couplés par communication avec le contrôleur (1132),
une interface de réseau (1160) couplée par communication avec l'appareil,
une batterie couplée à l'appareil (1100), ou
un afficheur couplé par communication avec l'appareil (1100).

9. Procédé comprenant :
la sélection d'une cellule de mémoire non volatile résistive (102) d'un composant mémoire (100) et la réalisation d'une première opération d'écriture de rafraîchissement sur ladite cellule de mémoire par l'intermédiaire de l'application d'une ou plusieurs tensions de polarisation de sélection sur la cellule de mémoire (902),
**caractérisé en ce que** le procédé comprend en outre :
la détermination de ce que ladite cellule de mémoire a été sélectionnée et de ce que la première opération d'écriture de rafraîchissement a été effectuée sur la base de ce qu'un événement de snap-back (822-2) a été détecté pour la cellule de mémoire alors que la ou les tensions de polarisation de sélection ont été appliquées (904), et
la sélection de ladite cellule de mémoire et la réalisation d'une seconde opération d'écriture de rafraîchissement sur ladite cellule de mémoire par l'intermédiaire d'une nouvelle application de la ou des tensions de polarisation de sélection sur la base de l'absence de détection d'un événement de snap-back pour la cellule de mémoire alors que la ou les tensions de polarisation de sélection ont été appliquées (906).

10. Procédé selon la revendication 9, comprenant la sélection de la cellule de mémoire (102) pour la première opération d'écriture de rafraîchissement (902) en réponse à l'expiration d'un intervalle de temps.

11. Procédé selon la revendication 10, comprenant en outre :
la détermination de ce que la cellule de mémoire (102) a été sélectionnée et de ce que la seconde opération d'écriture de rafraîchissement a été effectuée sur la base de ce qu'un événement de snap-back a été détecté pour la cellule de mémoire alors que la ou les tensions de polarisation de sélection ont été appliquées de nouveau (906), et
l'identification de la cellule de mémoire comme présentant une dérive de tension de seuil sur l'intervalle de temps qui provoque une défaillance de sélection sur la base de l'absence de sélection d'un événement de snap-back pour la cellule de mémoire lorsque la ou les tensions de polarisation de sélection ont été appliquées de nouveau.

12. Procédé selon la revendication 9, dans lequel les première et seconde opérations d'écriture de rafraîchissement comprennent des opérations d'écriture de réinitialisation (700).

13. Procédé selon la revendication 9, dans lequel la ou les tensions de polarisation de sélection comprennent une première tension de polarisation de sélection, qui représente la tension la plus élevée de polarisation de sélection pour sélectionner la cellule de mémoire pour une opération d'écriture de rafraîchissement dans une limite de temps de programmation, ainsi qu'une seconde tension de polarisation de sélection qui est inférieure à la tension la plus élevée de polarisation de sélection (500) .

14. Support pouvant être lu par une machine (1130) comprenant une pluralité d'instructions qui, en réponse à leur exécution par un système (1100) amènent le système à réaliser le procédé conforme à l'une quelconque des revendications 9 à 13.

15. Appareil selon la revendication 1, comprenant en outre la logique (1160) permettant de :
sélectionner des cellules de mémoire parmi la pluralité de cellules de mémoire et effectuer une première opération d'écriture de rafraîchissement sur lesdites cellules de mémoire sélectionnées par l'intermédiaire de l'application d'une ou plusieurs tensions de polarisation de sélection sur les cellules de mémoire (902),
déterminer si les cellules de mémoire ont été sélectionnées et si la première opération d'écriture de rafraîchissement a été effectuée sur la base de ce que des événements respectifs de snap-back ont été détectés pour les cellules de mémoire alors que la ou les tensions de polarisation de sélection ont été appliquées (904), et
sélectionner les cellules de mémoire et effectuer une seconde opération d'écriture de rafraîchissement sur lesdites cellules de mémoire sélectionnées par l'intermédiaire d'une nouvelle application de la ou des tensions de polarisation de sélection sur la base de l'absence de détection d'un événement de snap-back pour au moins une partie desdites cellules de mémoire alors que la ou les tensions de polarisation de sélection ont été appliquées (906).

16. Appareil selon la revendication 15, comprenant la logique permettant de sélectionner au moins une partie des cellules de mémoire sur la base d'une valeur anticipée d'un taux d'erreur binaire résiduel (RBER) (400) pour le composant mémoire provoquée par une défaillance de sélection de la ou des parties des cellules de mémoire.

17. Appareil selon la revendication 16, comprenant la logique (1160) permettant de sélectionner les cellules de mémoire pour la première opération d'écriture de rafraîchissement (902) en réponse à l'expiration d'un intervalle de temps.

18. Appareil selon la revendication 17, l'intervalle de temps comportant 48 heures.

19. Appareil selon la revendication 17, comprenant en outre la logique (1160) permettant de :
déterminer si les cellules de mémoire ont été sélectionnées et si la seconde opération d'écriture de rafraîchissement a été effectuée sur la base de ce qu'un événement de snap-back a été détecté pour la ou les parties des cellules de mémoire alors que la ou les tensions de polarisation de sélection ont été appliquées de nouveau (904), et
identifier chaque cellule de mémoire parmi la ou les parties des cellules de mémoire comme présentant une dérive de tension de seuil sur l'intervalle de temps qui provoque une défaillance de sélection sur la base de l'absence de détection d'un événement de snap-back alors que la ou les tensions de polarisation de sélection ont été appliquées de nouveau (906).

20. Appareil selon la revendication 15, dans lequel la ou les tensions de polarisation de sélection comprennent une première tension de polarisation de sélection, qui représente la tension la plus élevée de polarisation de sélection pour sélectionner la cellule de mémoire pour une opération d'écriture de rafraîchissement dans une limite de temps de programmation, ainsi qu'une seconde tension de polarisation de sélection qui est inférieure à la tension la plus élevée de polarisation de sélection (500) .

21. Appareil selon la revendication 15, dans lequel les cellules de mémoire non volatile (102) incluent une mémoire à changement de phase qui utilise un matériau de changement de phase à chalcogénure, une mémoire ferroélectrique, une mémoire, une mémoire à polymère, une mémoire à polymère ferroélectrique, une mémoire à accès direct à transistors ferroélectriques (FeTRAM ou FeRAM), une mémoire ovonique, une mémoire à nano fils, une mémoire à accès direct magnéto résistive (MRAM) ou une mémoire MRAM à couple de transfert de spin (STT-MRAM) .
